# EUROPEAN PATENT SPECIFICATION

(11) **EP 3 235 586 B1**
(45) Date of publication and mention of the grant of the patent: **20.11.2019**
(21) Application number: 15870038.5
(22) Date of filing: 16.12.2015
(51) Int. Cl.: B23K 35/14, B23K 35/40, C23C 26/00, B23K 35/02, B05D 1/00, C22C 11/00, C22C 11/06, C22C 13/00, B23K 35/26, B23K 35/365, H05K 3/34, B05D 7/20

(54) **COATED SOLDER WIRE AND METHOD FOR MANUFACTURING SAME**
BESCHICHTETER LÖTDRAHT UND VERFAHREN ZUR HERSTELLUNG DAVON
FIL DE SOUDURE REVÊTU ET SON PROCÉDÉ DE FABRICATION

(30) Priority: 19.12.2014 JP 2014257363; 08.05.2015 JP 2015095763
(43) Date of publication of application: 25.10.2017
(73) Proprietor: Sumitomo Metal Mining Co., Ltd., Tokyo 105-8716 (JP)
(72) Inventor: KOBAYASHI, Hiroshi, Ichikawa-shi Chiba 272-8588 (JP); YAMABE, Hidetoshi, Ichikawa-shi Chiba 272-8588 (JP)
(74) Representative: Rings, Rolf
(86) International application number: PCT/JP2015/085280
(87) International publication number: WO 2016/098836

(56) References cited:
- WO-A1-2017/018155
- JP-A- H0 919 794
- JP-A- 2006 088 205
- JP-A- 2006 088 205
- JP-A- 2014 103 380
- JP-A- 2014 195 831
- JP-A- 2014 195 831

## Description

### TECHNICAL FIELD

The present invention relates to a solder wire that is used when manufacturing a semiconductor device, and the manufacturing method thereof.

### BACKGROUND ART

In the manufacturing of a semiconductor bonding substrate, a semiconductor or the like, soldering is typically employed when bonding together metal members or when bonding electronic parts such as semiconductor elements to a printed circuit board. Solder material that is used in soldering is formed into various shapes such as wire, ribbon, sheet, preform material (punched material), balls, fine powder and the like.

Solder material oxidizes easily in the presence of oxygen, and an oxide film is formed in the surface during storage. Particularly, when using solder material after a long period of time has elapsed since the solder material was manufactured, oxidation advances and the oxide film becomes thick, which brings about a decrease in the wettability and bondability of the solder material, or causes bonding defects such as the occurrence of gaps (voids) or the like. In addition, solder material is melted at high temperature during use, so the oxide film becomes even thicker. When a thick oxide film that is formed in this way exists at the bonding interface, problems such as poor conductivity and a decrease in the bondability occur.

As technology for preventing oxidation of metal material and metal alloy material, a method of forming a coating film using surface treatment is known. Particularly, surface treatment that uses an atmospheric pressure plasma CVD method, makes it possible to form a dense coating film at comparatively low cost, so not only is the oxidation prevention effect high, but the film formation material does not diffuse into the room, so the method is very safe and is gaining a lot of attention.

For example, JP2004510571 (A) describes a method for forming a coating (coating film) made from polydimethylsiloxane or the like on the surface of a metal substrate or the like by introducing a liquid spray type coating formation material that is made from an organic silicon compound into an atmospheric pressure plasma discharge, and then exposing the substrate to this spray type coating formation material (coating material).

However, in the technology described in this literature, after supplying a reaction gas, carrier gas and coating material into an apparatus, plasmatization of the reaction gas and activation (radicalization) of the coating material to be atomized are performed simultaneously, so activation of the coating material becomes uneven, and it is difficult to uniformly form a dense coating film over the entire surface of the substrate. Moreover, the technology in this literature is not intended for preventing oxidation on the surface of the solder material, and does not take into consideration the behavior of the coating film when the solder material is melted, or the effect from the existence of a coating film on the wettability and bondability.

In regard to this, JP2014195831 (A) describes a manufacturing method for coated solder material that forms a 4 nm to 200 nm thick polysiloxane coating film by mixing and spraying an organic silicon compound together with a carrier gas into a plasma gas at atmospheric pressure to radicalize the organic silicon compound, and then while polymerizing the radicalized organic silicon compound, causing that radicalized organic silicon compound to react with the metal on the surface of the solder material. With this method, it is possible to instantaneously radicalize the organic silicon compound, so it is possible to uniformly form a dense coating material over the entire surface of the solder material while maintaining the basic structure of the organic silicon compound. Therefore, it becomes possible to prevent the advancement of oxidation when the solder material is stored for a long period of time or when melted without deterioration of the wettability or bondability of the solder material.

### [Related Literature]

### [Patent Literature]

[Patent Literature 1] JP2004510571 (A)
[Patent Literature 2] JP2014195831 (A)

### SUMMARY OF INVENTION

### [Problem to be Solved by Invention]

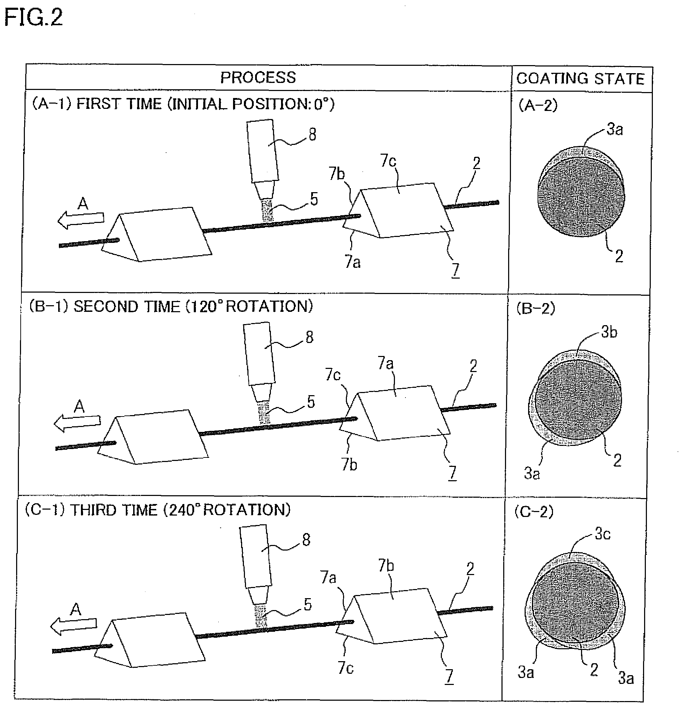

Incidentally, with the technology described in JP2014195831 (A), when coating the entire surface of a long solder wire, as illustrated in FIG. 2, it becomes necessary to process the base material solder wire 2 plural times (three times in the example in the figures). In other words, it is necessary that
(1) a transporting jig 7 that is able to prevent twisting of the solder wire 2 during transporting is fastened so that a surface 7a becomes the bottom surface side, and when transporting the solder wire 2 in the direction of the arrow A, radicalized organic silicon compound 5 is sprayed from a nozzle 8 to form a coating film 3a (refer to (A-1) in FIG. 2); then
(2) the transporting jig 7 is rotated 120° so that a surface 7b becomes the bottom surface side, and as in step (1), a coating film 3b is formed (refer to (B-1) in FIG. 2), and finally
(3) the transporting jig 7 further rotated 120° so that a surface 7c becomes the bottom surface side, and as in step (1) and step (2), a coating film 3c is formed (refer to (C-1) in FIG. 2).

Therefore, in the case that the technology described in JP2014195831 were to be applied as is to manufacturing on an industrial scale, it would be expected that productivity of coated solder wire would be greatly impaired. Moreover, as illustrated in (A-2), (B-2) and (C-2) of FIG. 2, thin portions of coating occur at the boundaries of the coating films 3a to 3c, so there is room for improvement for making the overall thickness of the coating film uniform.

Taking these problems into consideration, an object of the present invention is to provide a coated solder wire that is uniformly coated over the entire surface of the solder wire. Moreover, another object of the present invention is to provide a method for efficiently manufacturing this kind of coated solder wire in a single process.

### [Means for Solving Problems]

This problem is solved by means of a coated solder wire with the features of claim 1, as well as by means of the manufacturing method for a coated solder wire with the steps defined in claim 4. Preferred forms of realization of the invention are defined in the dependent claims.

The coated solder wire of the present invention is a coated solder wire that includes a solder wire and a coating film that is made from polysiloxane and that is provided on the surface of the solder wire; the coating film having a thickness of 4 nm to 200 nm, with the difference between the maximum value and minimum value of that thickness being within 2.5 nm, and the ratio of the coating film with respect to the overall coated solder wire being 200 ppm of mass or less in terms of silicon conversion.

As the solder wire, it is possible to suitably use a solder wire that comprises a solder alloy that includes Pb at 80% by mass or greater and at least one or more kind of a second element that is selected from among a group of Sn, Ag, Cu, In, Te and P, with the total content of the Pb and second element being 95% by mass or greater. Alternatively, it is possible to suitably use a solder wire that comprises a solder alloy that includes Sn at 80% by mass or greater and at least one or more kind of a second element that is selected from among a group of Ag, Sb, Cu, Ni, Ge and P, with the total content of the Sn and second element being 95% by mass or greater.

The manufacturing method for a coated solder wire of the present invention includes:
a radicalization step for forming a radicalized organic silicon compound by mixing a reaction gas that has been plasmatized under atmospheric pressure and an organic silicon compound that is introduced by way of a carrier gas, and radicalizing that organic silicon compound;
a reaction area formation step for forming a reaction area that is defined by a helical gas flow and in which the radicalized organic silicon compound is uniformly dispersed; and
a coating step for forming a 4 nm to 200 nm thick coating film made from polysiloxane on the surface of a solder wire by transporting the solder wire inside the reaction area and causing the radicalized organic silicon compound to react with metal on the surface of the solder wire.

Preferably, in the reaction area formation step, the reaction area is formed by mixing the radicalized organic silicon compound in a helical gas flow that is introduced beforehand. In this case, the helical gas flow is formed by at least one type of gas that is selected from among a group of argon, helium, nitrogen, oxygen and air.

Preferably, an organic silicon compound having at least one kind of organic substituent that is selected from among a group of an alkyl group, alkoxy group, fluoroalkyl group, amino group, epoxy group, isocyanate group, mercapto group, vinyl group, methacryloxy group, and acryloxy group is used as the organic silicon compound.

It is possible to use at least one kind of gas selected from among a group of argon, helium, nitrogen, oxygen and air as the reaction gas. Moreover, it is possible to use at least one kind of gas selected from among a group of argon, helium and nitrogen as the carrier gas.

Preferably, in the radicalization step, the organic silicon compound is radicalized by using an atmospheric pressure plasma polymerization processor.

In the radicalization step, the amount of the organic silicon compound introduced per 1 m of the solder wire is 0.006 g to 0.300 g. Moreover, the transporting speed of the solder wire in the coating step is preferably 1 m/min to 100 m/min.

### [Effect of Invention]

With the present invention, a coated solder wired having a dense polysiloxane coating film that is uniformly provided over the entire surface of solder wire can be provided. Moreover, with the present invention, a manufacturing method for efficiently manufacturing this kind of coated solder wire in a single process can be provided. Therefore, the present invention has very large industrial significance.

### BRIEF DESCRIPTION OF DRAWINGS

FIG. 1A is a perspective view for explaining the manufacturing method for coated solder wire of the present invention; and FIG. 1B is a cross-sectional view of the coated solder wire that is obtained by this manufacturing method.
FIG. 2 (A-1) to (C-1) are perspective views for explaining the manufacturing method for conventional coated solder wire; and FIGS. 2 (A-2) to 2(C-2) are cross-sectional views of coated solder wire in each stage.
FIG. 3A to FIG. 3D are cross-sectional TEM photographs of coated solder wire that is obtained in Example 2.
FIG. 4A and FIG. 4B are cross-sectional TEM photographs of coated solder wire that is obtained in Comparative Example 3.

### MODES FOR CARRYING OUT INVENTION

The inventors, as a result of repeated study of the problems described above, learned that a very uniform and dense coating film can be formed in a single process by forming a reaction area in which radicalized organic silicon compound is uniformly dispersed and the radicalized organic silicon compound can react with the metal on the solder wire surface in advance, and then by transporting the solder wire into that reaction area. Moreover, the inventors learned that this kind of reaction area can be formed by mixing radicalized organic silicon compound in a spiral gas flow. The present invention was obtained based on the obtained knowledge.

In the following, the present invention will be explained in detail by dividing the explanation into "1. Coated Solder Wire", "2. Manufacturing Method for Coated Solder Wire", and "3. Die Bonding Method Using Coated Solder Wire". The coated solder wire of the present invention is not limited by the diameter of the solder wire that is used as the base material, however, in the following explanation, an example will be given for the case in which typically used solder wire having a diameter of 0.3 mm to 1.0 mm is used.

### 1. Coated Solder Wire

The coated solder wire of the present invention includes a solder wire and a coating film that is made from polysiloxane and that is provided on the surface of the solder wire. This coating film has a thickness of 4 nm to 200 nm, with the difference between the value of the maximum thickness and the value of the minimum thickness (maximum difference) being within 2.5 nm, and the ratio of the coating film with respect to the overall coated solder wire is 200 ppm of mass or less in terms of silicon conversion.

### (1) Solder Wire

In the present invention, the composition of the solder wire is not particularly limited, and it is possible to use solder wire having various composition. However, when the present invention is applied to a solder wire having the composition described below, the effect of the present invention can be effectively exhibited. The composition of the solder wire can be found by ICP emission spectroscopy.

### a) Pb based Solder Wire

Pb based solder wire is made from a solder alloy having Pb (lead) as the main component, and includes at least one or more second element that is selected from among the group of Sn (tin), Ag (silver), Cu (copper), In (indium), Te (tellurium), and P (phosphorous). Having Pb as the main component means that the Pb content with respect to the overall solder alloy is 80% by mass or greater.

This kind of Pb based solder wire is extremely versatile and conventionally is used for various purposes. In recent years, taking into consideration the effect on the human body and on the environment, the use of Pb is restricted, however, from the aspect of versatility and ease of use, Pb based solder wire is still currently being used as a high-temperature solder in some uses such as bonding of power devices.

In Pb based solder wire, the total content of Pb and the second element is 95% by mass or greater, and preferably 97% by mass or greater. When the total content of Pb and the second element is less than 95% by mass, obtaining the characteristics described above is difficult.

The content of Pb is preferably no less than 80% by mass and no greater than 98% by mass, and more preferably is no less than 85% by mass and no greater than 98% by mass. Moreover, the content of the second element is preferably no less than 2% by mass and no greater then 15% by mass, and more preferably no less than 2% by mass and no greater than 12% by mass.

Moreover, in the case of Pb based solder wire, depending on the use and purpose, an element (third element) other than Pb and the second element can also be included. As the third element, it is possible to use, for example, Ni (nickel), Ge (germanium), Co (cobalt), Sb (antimony), Bi (bismuth) and the like. The content of the third element is preferably no greater than 5.0% by mass, and more preferably no greater than 4.5% by mass. When the content of the third element is greater than 5.0% by mass, due to the relationship with the Pb and second element content, it may not be possible to obtain the desired characteristics.

### b) Sn based Solder Wire

Sn based solder wire is made from a solder alloy that includes Sn as the main component and one or more kind of second element that is selected from among the group of Ag, Sb, Cu, Ni, Ge and P (phosphorous). Having Sn as the main component means that the content of Sn with respect to the overall solder alloy is 80% by mass or greater.

This kind of Sn based solder wire can preferably be applied to uses such as semiconductor devices having a low melting point, and can be used as so-called "lead-free solder". Here, lead free means that absolutely no lead is included, or when lead is included as an inevitable impurity, means that the content of the lead is less than 0.01% by mass.

In Sn based solder wire, the total content of Sn and second element is 95% by mass or greater, and preferably is 97% by mass or greater. When the total content of Sn and second element is less than 95% by mass, the characteristics described above cannot be obtained.

The Sn content is preferably no less than 80% by mass and no greater than 98% by mass, and more preferably no less than 90% by mass and no greater than 98% by mass. The content of the second element is preferably no less than 1% by mass and no greater than 10% by mass, and more preferably is no less than 2% by mass and no greater than 7% by mass.

Moreover, in the case of Sn based solder wire as well, depending on the use and purpose, it is possible to include an element (third element) other than Sn and the second element. As such a third element, it is possible to use, for example, Co, Bi and the like. The content of the third element is preferably 5.0% by mass or less, and more preferably 3.0% by mass or less. When the content of the third element is greater than 5.0% by mass, due to the relationship with the content of Sn and second element, it may not be possible to obtain the desired characteristics.

### (Coating Film)

### a) Composition and Structure

The coating film of the present invention is made from polysiloxane. The type of polysiloxane is arbitrary, however, from the aspect of suppressing the advancement of oxidation on the solder wire surface, the main chain has a siloxane bond -(Si-O-Si)n - (n = 1, 2, 3 ...), and preferably a polyalkylsiloxane to which 1 to 3 alkyl groups are bonded per unit Si is used, and particularly, using polydimethylpolysiloxane to which 2 to 3 methyl groups are bonded per unit Si is more preferred. This kind of polysiloxane coating film is highly dense, and as a result, can provide the solder wire with excellent oxidation resistance.

### b) Thickness

The thickness of the coating film is controlled to be 4 nm to 200 nm, and preferably 6 nm to 100 nm, and more preferably 8 nm to 50 nm. When the thickness of the coating film is less than 4 nm, it is not possible to sufficiently suppress the advancement of oxidation of the solder wire surface, and so problems such as a decrease in wettability and bondability, and the occurrence of gaps (voids) may occur. However, when the thickness of the coating film is greater than 200 nm, it is possible to suppress the advancement of oxidation of the solder wire surface, however, due to the effect of the coating film, problems such as a decrease in wettability and bondability of the solder wire, and the occurrence of gaps (voids) may occur.

The thickness of the coating film can be found by cutting the coated solder wire in the lengthwise direction at three or more locations in the circumferential direction, then observing each cross section using a transmission electron microscope (TEM).

### c) Uniformity of Thickness

This coating film also has excellent uniformity of thickness. More specifically, the coated solder wire of the present invention can be controlled so that the difference (maximum difference) in the maximum value and the minimum value of the thickness (dimension in the radial direction) of the coating film is within 2.5 nm over the entire coated solder wire (lengthwise direction and circumferential direction), and preferably within 2.0 nm, and more preferably within 1.5 nm. Therefore, the coated solder wire of the present invention can be said to have extremely small variations in characteristics such as oxidation resistance, wettability and bondability.

### d) Coating Amount

In the case of the coated solder wire of the present invention, the ratio of the coating film with respect to the overall coated solder wire is controlled to be 200 ppm of mass or less in terms of silicon conversion, and preferably 5 ppm of mass to 95 ppm of mass, and more preferably 7 ppm of mass to 50 ppm of mass. In this way, in the case of the coated solder wire of the present invention, the ratio of the coating film is an extremely small amount, so there is hardly any effect of the coating film on the wettability, bondability and the like of the solder wire.

### e) Characteristics

The coating film of the coated solder film of the present invention can be evaluated as having a strong bond with the metal of the solder wire surface and having excellent uniformity of thickness regardless of being formed to be extremely thin. Therefore, it is possible to suppress the advancement of oxidation on the solder wire surface, and as a result, it is possible to effectively suppress a decrease in wettability and bondability of the solder wire and the occurrence of gaps (voids).

Moreover, this coating film is colorless and transparent, and as described above, has excellent uniformity of thickness regardless of being formed to be extremely thin, so there is hardly any occurrence of external defects such a processing unevenness and spots.

### 2. Manufacturing Method for Coated Solder Wire

The manufacturing method for the coated solder wire of the present invention includes:
(1) a radicalization step of forming a radicalized organic silicon compound by mixing a reaction gas that has been plasmatized in atmospheric pressure and an organic silicon compound that is introduced via a carrier, and radicalizing the organic silicon compound;
(2) a reaction area formation step of forming a reaction area that is defined by a helical gas flow, and in which the radicalized organic silicon compound is uniformly dispersed; and
(3) a coating step of forming a 4 nm to 200 nm thick polysiloxane coating film on the surface of solder wire by transporting the solder wire into the reaction area, and causing the radicalized organic silicon compound to react with the metal on the solder wire surface.

With this kind of manufacturing method, a dense polysiloxane coating film can be uniformly formed on a solder wire in a single process, so when compared with the method described in JP2014195831 (A), it is possible to dramatically improve productivity. Moreover, this manufacturing method uses an organic silicon compound that is a liquid in the normal state as the coating material, and the coating film is formed by a dry method, so not only is the material easy to handle, but can also be evaluated as being excellent in terms of safety.

### (1) Radicalization Step

The radicalization step is a step for forming a radicalized organic silicon compound by mixing a reaction gas that has been plasmatized in atmospheric pressure and an organic silicon compound that is introduced via a carrier, and radicalizing the organic silicon compound.

### a) Atmospheric Pressure Plasma Polymerization Processing

Plasma polymerization processing is known technology, however, the plasma polymerization processing that is used in the present invention causes a chemical reaction that does not normally proceed to proceed by activation of reactive particles by atmospheric pressure plasma. This kind of atmospheric pressure plasma polymerization processing is suitable for continuous processing, so productivity is high, and there is no need for vacuum equipment, so processing cost is low, and it is possible to simplify the equipment configuration.

As the atmospheric pressure plasma, it is possible to use corona discharge, dielectric barrier discharge, RF discharge, microwave discharge, arc discharge and the like, however, in the present invention, the atmospheric pressure plasma is not particularly limited, and any atmospheric pressure plasma can be suitably applied. Therefore, the device used for plasmatization is not particularly limited as long as it is possible to perform plasmatization of a reaction gas under atmospheric pressure, and it is possible to use a known plasma generating device. In the present invention, atmospheric pressure includes atmospheric pressure (1013.25 hPa) and air pressure in that vicinity, and air pressure within the normal range of change in atmospheric pressure is also included.

However, in the present invention, it is necessary to mix and spray organic silicon compound via a carrier gas into reaction gas that has been plasmatized beforehand. By using this kind of configuration, differing from a method for forming a coating film that uses a conventional atmospheric pressure plasma CVD method in which plasmatization of reaction gas and activation (plasmatization) of the coating material is performed simultaneously, the organic silicon compound can be instantaneously radicalized, so it is possible to uniformly form a dense polysiloxane coating film over the entire surface of the solder wire while maintaining the basic structure of the organic silicon compound.

### b) Plasmatization Conditions

The conditions for plasmatizing the reaction gas are appropriately selected according to the plasma device used and the thickness of the intended coating film, however, from the aspect of efficiently radicalizing the organic silicon compound and forming a high-quality coating film, preferably the generator output voltage is within the range 150V to 350V, and more preferably within the range 200V to 330V. When the generator output voltage is less than 150V, it is not possible to sufficiently plasmatize the reaction gas, so it may not be possible to sufficiently radicalize the hydrocarbons. However, when the output voltage is greater than 350V, a problem may occur in that the device could be damaged.

### c) Reaction Gas

The reaction gas is not particularly limited as long as the gas can be easily plasmatized, and for example, it is possible to use Ar (argon), He (helium), N₂ (nitrogen), O₂ (oxygen), air and the like. Of these gases, one gas can be used alone, or it is also possible to use two or more that are mixed together in a specified ratio. From the aspect of production cost, using N₂, O₂, or a mixture of these is used, and particularly using air is preferred.

### b) Carrier Gas

The carrier gas is not particularly limited, and as long as the gas is able to transport the sprayed organic silicon compound. For example, Ar, He, N₂ and the like can be used. Of these carrier gasses, one can be used alone, or it is also possible to use two or more that have been mixed in a specified ratio. From the aspect of production cost, using N₂ is preferred.

### c) Organic Silicon Compound

In the present invention, an organic silicon compound that is a liquid in the normal state can be used as the coating material for forming a coating film. As this kind of organic silicon compound, using a compound having at least one or more kind of organic substituent that is selected from among the group of an alkyl group, alkoxy group, fluoroalkyl group, amino group, epoxy group, isocyanate group, mercapto group, vinyl group, methacryloxy group, and acryloxy group is preferred.

More specifically, as a compound having an alkyl group, tetramethyldisiloxane (TMDSO), hexamethyldisiloxane (HMDSO), octamethyltrisiloxane (OMTSO), decamethyltetrasiloxane (DMTSO), octamethylcyclotetrasiloxane (OMCTSO), hexamethylcyclotrisiloxane (HMCTSO), octamethylcyclotetrasiloxane (OMCTSO), decamethylcyclopentasiloxane (DMCPSO), tetramethylcyclotetrasiloxane (TMCTSO) and the like can be used.

As a compound having an organic substituent such as an alkoxyl group, fluoroalkyl group and the like, it is possible to use methyltrimethoxysilane, methyltriethoxysilane, methyltriisopropoxysilane, ethyltrimethoxysilane, ethyltriethoxysilane, ethylitriisopropoxysilane, propyltrimethoxysilane, propyltriethoxysilane, propyltriisopropoxysilane, phenyltrimethoxysilane (PTMEOS), allytrimethoxysilane, γ-glycidoxypropyltrimethoxysilane (GPTMO S), γ-glycidoxypropyltriethoxysilane, γ-chloropropyltrimthoxysilane, tris (3-triethoxysilylpropyl)isocyanurate, 4-trimethoxysilylpropyloxy-2-hydroxybenzophenone, dimethyldimethoxysilane, dimethyldiethoxysilane, methylethyldimethoxysilane, diethyldimethoxysilane, diethyldiethoxysilane, methylpropyldimethoxysilane, methylpropyldiethoxysilane, diisopropyldimethoxysilane, phenylmethyldimethoxysilane, γ-glycidoxypropylmethyldimethoxysilane, γ-glycidoxypropylmethyldiethoxysilane, tetramethoxysilane, tetraethoxysilane, heptadecafluorodecylmethoxysilane, trifluoropropyltrimethoxysilane (TFPTMO S), pentafluorobutyltripropoxysilane, perfluorohexylethylmethoxysilane, perfluoropentylethyltrimethoxysilane, perfluorohexylethylethoxysilane, perfluorooctylethyltrimethoxysilane, perfluoropentylethylmethyldiethoxysilane, perfluorooctylethylmethyldiethoxysilane, perfluoropentylethylmethyldipropoxysilane, γ-aminopropyltrimethoxysilane, γ-aminopropyltriethoxysilane, N-(2-aminoethyl) aminopropyltrimethoxysilane, γ-aminopropylmethyldiethoxysilane, N-(2-aminoethyl) aminopropylmethyldimethoxysilane, β-(3, 4-epoxycyclohexyl) ethyltrimethoxysilane, β-(3,4-epoxycyclohexyl) ethylmethyldimethoxysilane, γ-isocyanate propyltrimethoxysilane, γ-isocyanate propyltriethoxysilane, tris (3-trimethoxysilylpropyl) isocyanurate having isocyanate groups bonded to each other, γ-mercaptopropyltrimethoxysilane, γ-mercaptopropylmethyldimethoxysilane, vinyltrimethoxysilane, vinylmethyldimethoxysilane, γ-methacryloxypropyltrimethoxysilane, γ-methacryloxypropyltriethoxysilane, γ-methacryloxypropylmethyldimethoxysilane, γ-methacryloxypropylmethyldiethoxysilane, γ-acryloxypropyltrimethoxysilane and the like.

Even among these, a compound having an alkyl group, and particularly, hexamethyldisiloxane (HMDSO) is a colorless and odorless liquid having a boiling point at 99.5°C, displays high stability in air and is easy to handle, so can be suitably used.

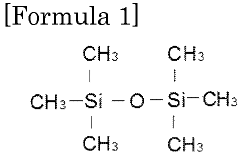

### d) Amount of Organic Silicon Compound Introduced

The amount of organic silicon compound that is introduced differs according to the diameter of the solder wire on which a coating film will be formed, plasmatization conditions and the like, however, when a typical solder wire (diameter: 0.3 mm to 1.0 mm) is to be used, the amount of organic silicon compound introduced per 1 meter of solder wire is preferably 0.006 g to 0.300 g, and more preferably 0.010 g to 0.200 g, and even more preferably 0.012 g to 0.075 g. When the amount of organic silicon compound that is introduced is less than 0.006 g, the thickness of the coating film becomes 4 nm or less, and there is a possibility that variation in the thickness will occur. However, when the amount of organic silicon compound that is introduced is greater than 0.300 g, there is a possibility that the thickness of the coating film will become greater than 200 nm.

### (2) Reaction Area Formation Step

The reaction area formation step is a step for forming a reaction area in which the organic silicon compound that is obtained in the radicalization step is uniformly dispersed and is defined by a helical shaped gas flow.

### a) Reaction Area

In the manufacturing method for a coated solder wire of the present invention, it is essential that a reaction area in which the radicalized organic silicon compound is uniformly dispersed and in which that organic silicon compound can react with the metal on the solder wire surface be formed in advance. The state of the organic silicon compound in this reaction area in not limited as long as the organic silicon compound is radicalized, and this organic silicon compound may be in the state of a monomer, a semi-polymer, or a polymer.

Moreover, in the manufacturing method of the coated solder wire of the present invention, this reaction area must be defined by a helical gas flow. This is because, by forming a helical gas flow in which radicalized organic silicon compound is uniformly dispersed, and causing a reaction of the metal on the surface of the solder wire and the radicalized organic silicon compound to advance simultaneously and at about the same reaction speed, it is possible to form the obtained coating film very uniformly.

The method for forming a reaction area defined by such a helical gas flow is not particularly limited. For example, the reaction area can be formed by introducing a helical gas flow beforehand inside the device, and mixing the radicalized organic silicon compound that is generated in the radicalization step described above with that helical gas flow. Moreover, it is also possible to perform the radicalization step outside the device and to introduce the generated radicalized organic silicon compound into the inside of the device using as a helical gas flow using a carrier gas. However, when considering that radicalized organic silicon compound is not stable and could soon return to normal organic silicon compound, the former method can be said to be preferred.

### b) Helical Gas Flow

The helical gas flow can be formed by introducing one or more kind of gas selected from among the group of argon, helium, nitrogen, oxygen and air, or in other words, a gas similar to the carrier gas described above, or by introducing radicalized organic silicon compound that is generated outside the device and that is mixed with these gases inside the device so as to flow in a helical shape. However, when forming a thin coating film, forming a helical gas flow using oxygen or air (particularly dry air) is preferred. When oxygen or air is used, it is possible to increase the amount of oxygen introduced into the coating film, and as a result, it becomes possible to further improve the denseness and smoothness of the coating film.

The helical gas flow must be formed so that the cross-sectional area of the flow is larger than the diameter of the solder wire that is to be coated. Moreover, the speed of the helical gas flow (speed in the advancing direction and the speed in the circumferential direction must be appropriately selected according to the intended thickness of the coating film and the characteristics of the solder wire (reactivity with the organic silicon compound). Therefore, preferably the speed of the helical gas flow is set after performing tests beforehand.

### (3) Coating Step

The coating step is a step for forming a 4 nm to 200 nm thick polysiloxane coating film on the solder wire surface by causing the radicalized organic silicon compound to react with the metal on the surface of the solder wire.

### a) Solder Wire

The solder wire of the coated solder wire of the present invention is not particularly limited, and it is possible to use various kinds of solder wire. However, in order to sufficiently demonstrate the effect of the present invention, a solder wire that is obtained by the formation method explained above is preferably used.

### [Melting the Raw Material]

As the method for melting the raw material, it is possible to use known means such as a resistance heating method, reduction diffusion method, high-frequency dissolution method and the like, and particularly, a high-frequency dissolution method by which it is possible to efficiently melt the raw material in a short amount of time is preferred. By casting the raw material that is melted by these methods into a mold that has been prepared beforehand, a mother alloy ingot having a specified shape is formed. When oxygen is present during melting and casting, not only does oxidation of the raw material advance, but an oxide film is formed during casting, the thickness of oxide film on the surface of the obtained solder wire becomes thick, and the surface roughness (Ra) increases. Therefore, preferably the atmosphere during melting of the raw material is an inert gas atmosphere, and during casting, inert gas is made to flow at the molten inlet of the mold.

### [Solder Wire]

When forming wire shaped solder, the solder mother alloy ingot is formed by an extrusion method or wire drawing method. For example, when forming the ingot by an extrusion method, it is necessary to select a suitable extrusion temperature according to the composition of the solder wire. This is because, when the extrusion temperature is too high, it becomes easy for oxidation of the surface to advance, and when the extrusion temperature is too low, solder wire is extruded in a hard state, so the formation time becomes long.

Moreover, extrusion is preferably performed in an inert gas, and performing extrusion in a sealed state with circulating inert gas is even more preferable. This is because, when oxygen is present during extrusion, the wire that is heated to the extrusion temperature is easily oxidized.

### [Acid Cleaning and Polishing]

In order to make the oxide film on the surface of the solder wire thin, and to reduce the surface roughness (Ra), preferably acid cleaning and polishing is performed. The timing at which acid cleaning and polishing is performed, can be timing after casting the solder mother alloy ingot and before, during or after performing specified processing.

The kind of acid used when performing acid cleaning is not particularly limited as long as the acid is suitably selected according to the composition of the solder wire, and it is possible to use both inorganic and organic acids, however, when taking cost into consideration, using an inorganic acid that is inexpensive and effective in removing oxide film is preferred. More specifically, as inorganic acid, it is possible to use hydrochloric acid, sulfuric acid, nitric acid, phosphoric acid, acetic acid and the like. Moreover, as organic acid, it is possible to use citric acid, oxalic acid and the like. However, using a strong acid causes the speed of dissolving the solder wire in the acidic solution to become fast, and it is possible that partial dissolution will occur, the surface roughness (Ra) will become large, and a change in composition will occur. Therefore, preferably, a weak acid having a slow dissolution speed and that is easy to handle is used. In acid cleaning, it is necessary to take the acid concentration, the cleaning speed and the cleaning temperature into sufficient consideration.

For example, when cleaning a Pb based solder wire using a 5% acetic acid aqueous solution, preferably acid cleaning is performed at a cleaning temperature of approximately 20°C and cleaning time of approximately 15 minutes. In this case, the oxide film on the solder wire is such that the greatest amount is dissolved immediately after coming in contact with the acetic acid aqueous solution, and gradually decreases after that, and becomes saturated at a certain state. More specifically, when cleaning an oxide film that is about 100 µm thick, the thickness of the oxide film becomes thinner, about 20 µm to 30 µm, after about 5 minutes, and becomes even thinner, about 10 µm, after about 15 minutes.

However, when polishing the surface of the solder wire, the polishing method is not particularly limited. For example, polishing can be performed by sandwiching the solder wire between abrasive paper, pressing with a suitable force, and winding the solder wire up while pulling.

### b) Reaction Between the Radicalized Organic Silicon Compound and Metal on the Solder Wire Surface

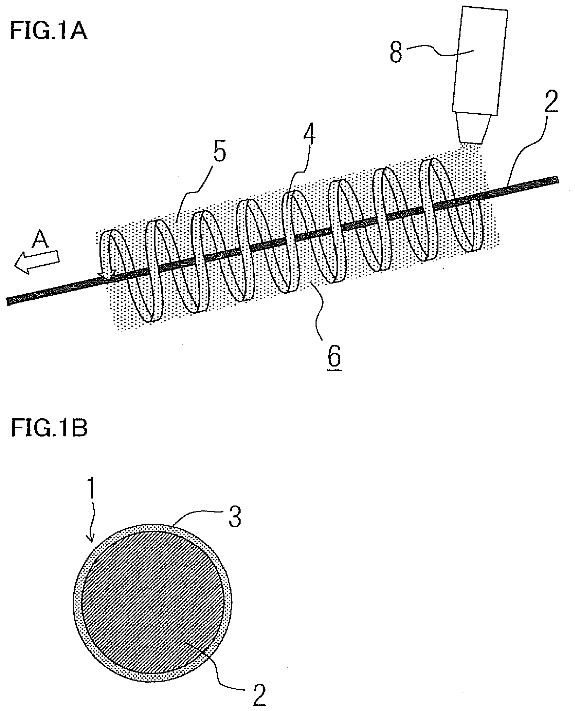

In the manufacturing method for coated solder wire of the present invention, the reaction between the radicalized organic silicon compound and metal on the solder wire surface advances inside the reaction area described above. More specifically, as illustrated in FIG. 1A, the solder wire 2 base material is transported in the direction of arrow A through the approximate center section of the reaction area 6 that is defined by a helical gas flow 4. When doing this, the radicalized organic silicon compound is uniformly dispersed inside the reaction area 6, so by the action of the helical gas flow 4, the radicalized organic silicon compound equally comes in contact with the entire surface of the solder wire 2. As a result, the reaction between the radicalized organic silicon compound 5 and the metal on the surface of the solder wire 5 advances simultaneously and at about the same reaction speed.

Incidentally, inside the reaction area 6 described above, the radicalized organic silicon compound 5 exists in various forms such as a monomer, a semi-polymer and a polymer. Therefore, as the reaction between the radicalized organic silicon compound and the metal on the surface of the solder wire 2, there is:
(i) a form in which the radicalized organic silicon compound 5 is polymerized after reacting with the metal on the surface of the solder wire 2;
(ii) a form in which the radicalized organic silicon compound 5 reacts with the metal on the surface of the solder wire 2 while being polymerized; or
(iii) a form in which the radical organic silicon compound 5 reacts with the metal on the surface of the solder wire 2 after being polymerized. In the manufacturing method for manufacturing the coated solder wire of the present invention, coating of the coating film described above is not limited to any of the forms as long as it is possible to obtain solder wire provided with a coating film.

### c) Transporting Speed of Solder Wire

The coated solder wire of the present invention is such that the thickness of the coating film is adjusted to be in the range 4 nm to 200 nm. This kind of coating film thickness can be controlled by the amount of organic silicon compound that is introduced as the coating material, the speed of the helical gas flow and also by the transporting speed of the solder wire. More specifically, the transporting speed of the solder wire in the coating process is preferably 1 m/min to 100 m/min, and more preferably 5 m/min to 80 m/min, and even more preferably 10 m/min to 50 m/min. When the transporting speed of solder wire is less than 1 m/min, not only is there a possibility that the coating film will become too thick, but productivity is remarkably lowered. However, when the transporting speed is greater than 100 m/min, there is a possibility that the thickness of the coating film will become less 4 nm or less, or that variation in the thickness will occur.

### 3. Die Bonding Method Using Coated Solder Wire

The coated solder wire of the present invention can be used to bond various semiconductor elements to a substrate, and more specifically, can be used to bond many kinds of semiconductor elements such as discrete components, IC (integrated circuit) chips, modules and the like to a substrate. In the following, a die bonding method for bonding an IC chip to the die portion of a lead frame using the coated solder wire of the present invention will be explained.

When performing die bonding using the coated solder wire of the present invention, in order to keep the IC chip horizontal, preferably high melting point particles are added to the solder wire. As the high melting point particles, using particles having a melting point that is 50°C or higher than the melting point of the solder wire is preferred, and more specifically, it is possible to use metal particles such as Cu, Ni and the like, oxide particles such as SiO₂ and the like, and carbide particles such as SiC and the like. These high melting point particles preferably have an average particle size of 1 µm to 70 µm. Moreover, the amount of high melting point particles contained is preferably 1% by mass to 40% by mass with respect to the solder wire.

In typical die bonding, a heater unit is provided in a partially closed chamber that is provided with an opening section for supplying solder wire or semiconductor elements, and the substrate is transported to this heater unit and heated. When doing this, an inert gas or forming gas (gas obtained by mixing hydrogen as a reducing gas with an inert gas) is made to flow and circulate inside the chamber. After that, solder wire is supplied to the top of the substrate that is heated to a specified temperature, and the solder wire is melted, then a semiconductor element is placed on top of the solder, and by applying pressure, the substrate and semiconductor element are bonded.

At this time, the solder wire waits in a state in which a heated gas mixture of inert gas and air are blown into the heater unit, so oxidation of the surface of the solder wire advances. Moreover, since inert gas is circulating and flowing, the inside of the chamber cannot be said to be completely closed, so when supplying the solder wire, oxidation also advances due to the oxygen that flows inside the chamber.

In addition, in order to perform good bonding, the temperature of the heater unit must be set to a high temperature that is about 30°C to 70°C higher than the melting point of the solder wire. Particularly, when using a high melting point solder such as a Pb based solder wire that includes Sn at 5% by mass, the temperature of the heater unit must be set to about 340°C to 380°C, and as a result, oxidation of the solder wire further advances.

In this kind of die bonding, by using the coated solder wire of the present invention instead of conventional solder wire, the action of the coating film makes it possible to prevent oxidation when waiting or during melting. Therefore, with the coated solder wire of the present invention, it is possible to achieve bonding that has excellent wettability and bondability, and has little occurrence of gaps, and with the manufacturing method of the present invention, production of a coated solder wire having such characteristics can be easily achieved on an industrial scale. Therefore, the coated solder wire of the present invention can be suitably used in a semiconductor element bonding substrate that requires high reliability, and in the production of various devices that use such a substrate.

### [Examples]

In the following, the present invention will be explained in further detail with reference to examples.

### [Production of Solder Wire]

As raw material, 99.9% pure or greater Bi, Zn, Ag, Sn, Pb, Cu, Au, In, Al, Ni, Sb, Ge, Te and P were prepared. In order to prevent variation in the composition of the obtained coated solder wire due to sampling position, large flakes or bulk materials were adjusted to a size of 3 mm or less by cutting or pulverizing.

A specified amount of the raw material that is adjusted in this way was weighed, and put into a graphite crucible. The crucible was then placed inside a high-frequency melting furnace, and in order to suppress oxidation, nitrogen was allowed to circulate and flow at a rate of 0.7 L/min per 1 kg of raw material, and in this state, the electric power to the melting furnace was turned ON, and the raw material was melted while sufficiently stirring with a mixing rod so that localized variation of the composition did not occur. After confirming that the raw material was sufficiently melted, the electric power to the melting furnace was turned OFF and the crucible was quickly removed, then the obtained molten metal was poured into molds of solder mother alloy, and solder mother alloy ingots having different compositions were obtained.

The molds that were used were the same as a typical mold that is used when casting the solder mother alloy. By processing each of the solder mother alloy ingots in an atmosphere of inert gas using an extrusion processing machine to form a wire shape, solder wire samples No. 1 to No. 18 (0.76 mm diameter) were obtained. The compositions of these solder wires were measured using an ICP emission spectroscopic analyzer (ICPS-8100, manufactured by Shimadzu Corporation). The results are given in Table 1.

**[Table 1]**

| | Sample | Composition (% by mass) | | | | | | | | | | |
|---|---|---|---|---|---|---|---|---|---|---|---|---|
| | | Ag | Sn | Pb | Cu | Au | In | Ni | Sb | Ge | Te | P |
| Pb based Solder Wire | 1 | 2.5 | 5.0 | Remnant | - | - | - | - | - | - | - | - |
| | 2 | 2.5 | 2.0 | Remnant | - | - | - | - | - | - | - | - |
| | 3 | 2.0 | 10.1 | Remnant | - | - | - | - | - | - | - | - |
| | 4 | 2.5 | 2.0 | Remnant | 0.1 | - | - | - | - | - | - | 0.06 |
| | 5 | 2.5 | - | Remnant | - | - | 5.1 | - | - | - | - | - |
| | 6 | 2.4 | 2.1 | Remnant | - | - | - | - | - | - | 0.05 | - |
| | 7 | - | 3.0 | Remnant | - | - | - | - | - | - | - | - |
| | 8 | - | 5.2 | Remnant | - | - | - | - | - | - | - | - |
| Sn based Solder Wire | 9 | - | 10.1 | Remnant | - | - | - | - | - | - | - | - |
| | 10 | 3.5 | Remnant | - | - | - | - | - | - | - | - | - |
| | 11 | 5.0 | Remnant | - | - | - | - | - | - | - | - | - |
| | 12 | 10.1 | Remnant | - | - | - | - | - | - | - | - | - |
| | 13 | 3.5 | Remnant | - | 0.5 | - | - | 0.06 | - | 0.01 | - | - |
| | 14 | - | Remnant | - | - | - | - | - | 3.5 | - | - | - |
| | 15 | - | Remnant | - | - | - | - | - | 8.5 | - | - | - |
| | 16 | - | Remnant | - | - | - | - | 0.60 | 7.0 | - | - | 0.05 |
| | 17 | 3.0 | Remnant | - | 0.5 | - | - | - | - | - | - | - |
| | 18 | 1.0 | Remnant | - | 0.2 | - | - | - | - | - | - | - |

### (Example 1)

### [Production of Coated Solder Wire]

When winding up the Pb based solder wire of sample No. 1 using a solder wire automatic winding machine (TM winding machine, manufactured by Tanabe Manufacturing Co., Ltd.), using a method such as illustrated in FIG. 1, a polysiloxane coating film was formed on the surface of the transported solder wire using an atmospheric pressure polymerization processor (Plasma polymer laboratory system model PAD-1, manufactured by Plasma Treat Co., Ltd.).

First, HMDSO (manufactured by Kanto Chemical Co., Ltd.) that was introduced by way of a carrier gas was mixed with a reaction gas (N₂) that was plasmatized under atmospheric pressure, and by radicalizing the HMDSO, radicalized HMDSO was obtained (radicalization step).

### <Plasmatization Conditions>

- Oscillation frequency of the plasma generator: 21 kHz
- Output voltage of the generator: 280 V
- Pressure: Atmospheric pressure (1013.25 hPa)

Meanwhile, N₂ was introduced into the device as the helical gas flow, and the radicalized HMDSO was sprayed into this helical gas flow from the nozzle of the atmospheric pressure polymerization processor, and by mixing the helical gas flow and the radicalized HMDSO, a reaction area was formed (reaction area formation step).

In this state, by passing the solder wire through the approximate center section of the reaction area, a coating film was formed on the surface of the solder wire. When doing this, the reacted amount of radicalized organic silicon compound per 1 m of solder wire was adjusted to 0.022g, and the transporting speed of the solder wire was adjusted 15.0 m/min.

### [Evaluation of the Coated Solder Wire]

The coated solder wire obtained as described above was evaluated according to items (a) to (e) below.

### (a) Measurement of the Thickness of the Coating Film

The coated solder wire was cut along the lengthwise direction at a reference position (0°), and at positions rotated 90° and 180° with respect to the reference position (0°) after which each cross section was observed using a TEM (transmission electron microscope HF-2000, manufactured by Hitachi High-Technologies Corporation), and the thickness of the coating film was measured. The results are given in Table 3.

### (b) Evaluation of the Surface State

The surface state at the time that the coated solder wire was made was observed using an optical microscope (ECLIPSE M6600, manufactured by Nikon Corporation). As a result, the surface state was evaluated as being "good (O)" when the state was mostly the same as the state when a coating film is not formed, and evaluated as "bad (X)" when discoloration was seen.

Moreover, a neutral salt spray test according to JISX237 was performed for seven days, after which the surface state was observed using an optical microscope. As a result, the surface state was evaluated as being "good (O)" when the state was mostly the same as the initial state, and evaluated as "bad (X)" when there was discoloration compared with the initial state, or when the smoothness was deteriorating. These results are given in Table 3.

Observation of the surface state in the initial state and after the neutral salt spray test was performed at a reference position (0°) and at positions rotated 90° and 180° with respect to the reference position (0°).

### (c) Evaluation of the Silicon Content

The amount of silicon on the surface of the coated solder wire was measured and evaluated by using an ICP emission spectroscopic analyzer.

### (d) Evaluation of Wettability (Wettability and Bondability)

After covering the heater section of a controlled atmosphere type wettability tester (manufactured by Sumitomo Metal Mining Co., Ltd.) with a double cover, N₂ was made to flow from four locations around the heater section at a flow rate of 12 L/min, and the heater temperature was set to a temperature 50°C higher than the melting point of the coated solder wire, and the coated solder wire was heated. After it was confirmed that the heater temperature was stable, a Cu substrate (plate thickness: approximately 0.70 mm) was set in the heater section and heated for 25 seconds. In this state, the coated solder wire that was cut to 5 cm was placed on the Cu substrate and further heated for 25 seconds. After that, the Cu substrate was removed from the heater section and cooled in a nitrogen atmosphere to room temperature. After it was confirmed that the Cu substrate was sufficiently cooled, the bonded state of the solder was visually observed.

As a result, the Cu substrate and the coated solder wire were bonded, and evaluated as being "good (O)" when the wettability of the coated solder wire was good (the solder after bonding was thinly spread), evaluated as being "bad (Δ)" when the wettability of the coated solder wire was bad (the solder after bonding was raised), and evaluated as "No good (X)" when bonding was not possible. The results are given in Table 3.

### (e) Evaluation of the Heat Cycle Characteristic

500 cycles of a heat cycle test, with one cycle consisting of cooling at -55°C and heating at +150°C, was performed on a Cu substrate to which coated solder wire was bonded in the wettability evaluation described above, after which the entire Cu substrate was embedded in resin, cross-section polishing was performed, and the bonded surface was observed using a SEM (scanning electron microscope S-4800, manufactured by Hitachi High-Technologies Corporation. As a result, the heat cycle characteristic was evaluated as being "good (O)" when the bonded surface was maintained in the same state as the initial state, and was evaluated as being "bad (X)" when peeling of the bonded surface occurred, or when cracking occurred in the coated solder wire. The results are given in Table 3.

### (Examples 2 to 26, Comparative Examples 1, 2)

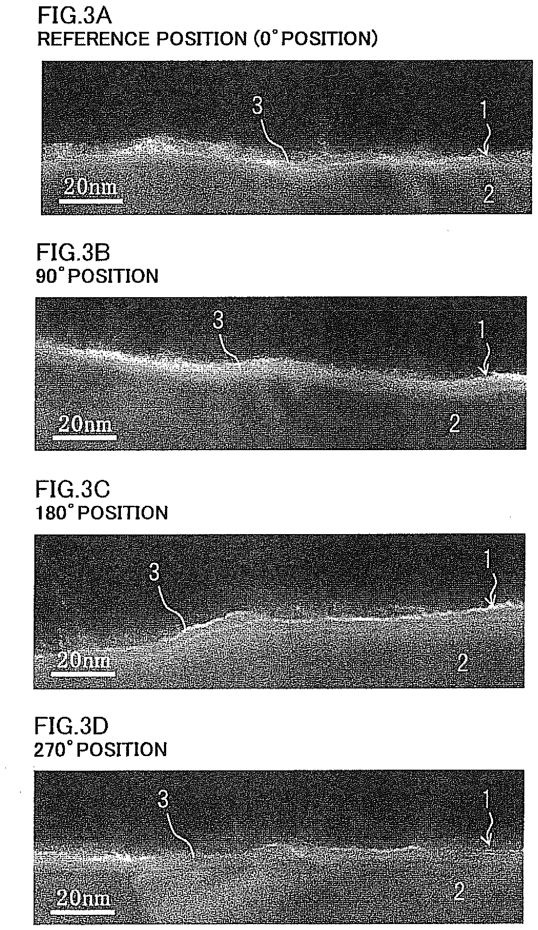

Except for changing the coating material and the processing conditions as presented in Table 2, coated solder wire was made in the same way as in Example 1, and evaluated according to items (a) to (e) above. The results are given in Table 3. Moreover, for the coated solder wire obtained in Example 2, cross-sectional TEM photos at a reference position (0°), and at positions rotated 90°, 180° and 270° with respect to the reference position are given in FIGS. 3A to 3D.

### (Comparative Example 3)

When winding up the Pb based solder wire of sample No. 1 using a solder wire automatic winding machine, polysiloxane coating film was formed on the surface of the transported solder wire by a method such as illustrated in FIG. 2 using an atmospheric pressure polymerization processor (Plasma polymer laboratory system model PAD-1, manufactured by Plasma Treat Co., Ltd.).

First, (1) a transport jig 7 that is able to prevent the solder wire 2 from twisting while being transported was fastened so that a surface 7a became the bottom surface side, and in this state, a coating film 3a was formed by spraying radicalized organic silicon compound from a nozzle 8 while the solder wire 2 was transported in the direction of arrow A (refer to (A-1) in FIG. 2. Next, (2) the transport jig 7 was rotated 120° so that the surface 7b became the bottom surface side, after which a coating film 3b was formed in the same way as in process (1) (refer to (B-1) in FIG. 2). Finally, (3) the transport jig 7 was further rotated 120° so that the surface 7c became the bottom surface side, after which a coating film 3c was formed in the same way as in process (1) and process (2) (refer to (C-1) in FIG. 2).

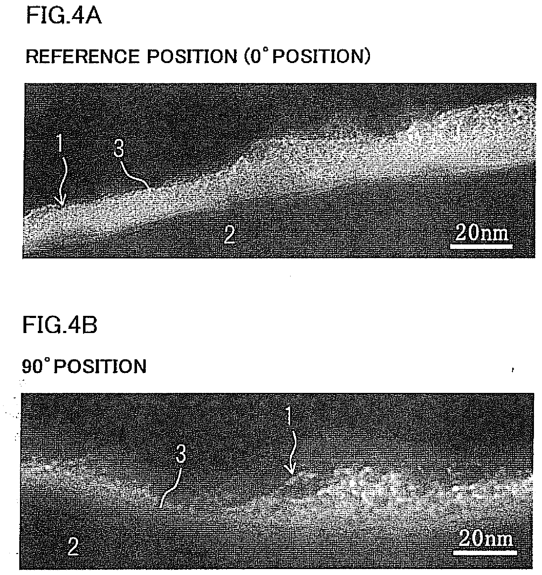

The coated solder wire obtained in this way was evaluated according to items (a) to (e) above. The results are given in Table 3. Moreover, the cross-section TEM photos at a reference position (0°) and at a position rotated 90° with respect to the reference position are given in FIGS. 4A and 4B.

### (Comparative Example 4)

When winding up the Pb based solder wire of sample No. 1 using a solder wire automatic winding machine, a coated solder wire was made by immersing the solder wire in a silicon based coating agent (APZ6601, manufactured by Dow Corning Toray) for 10 minutes, after which the solder wire was dried for 10 minutes at 120°C.

Evaluation of the coated solder wire that was obtained in this way was performed according to items (a) to (d) above. The results are given in Table 3. In Comparative Example 4, the coated solder wire and Cu substrate could not be bonded in (d) wettability evaluation, so (e) heat cycle characteristic evaluation was not performed.

### (Comparative Example 5)

When winding up the Pb based solder wire of sample No. 1 using a solder wire automatic winding machine, a coated solder wire was made by immersing the solder wire in a fluorine based coating agent (FG-3020C30, manufactured by Fluoro Technology Co., Ltd.) for 10 minutes, after which the solder wire was dried for 10 minutes in a cold air flow.

Evaluation of the coated solder wire that was obtained in this way was performed according to items (a), (b) and (d) above. The results are given in Table 3. In Comparative Example 5, the coated solder wire and Cu substrate could not be bonded in (d) wettability evaluation, so (e) heat cycle characteristic evaluation was not performed.

### (Comparative Example 6)

A coating film was not formed on the Pb based solder wire of sample No. 1, and evaluation was performed according to items (b), (d) and (e) above.

**[Table 2]**

| | Solder Wire (Sample No.) | Coating Material | | Coating Method | Processing Conditions | | |
|---|---|---|---|---|---|---|---|
| | | Type | Used Amount (g/m) | | Reaction Gas | Helical Gas Flow | Transporting Speed (m/min) |
| Ex. 1 | 1 | HMDSO | 0.022 | FIG. 1 | N₂ | N₂ | 15 |
| Ex. 2 | 1 | HMDSO | 0.011 | FIG. 1 | N₂ | N₂ | 15 |
| Ex. 3 | 1 | HMDSO | 0.006 | FIG. 1 | N₂ | N₂ | 15 |
| Ex. 4 | 1 | HMDSO | 0.167 | FIG. 1 | N₂ | N₂ | 15 |
| Ex. 5 | 1 | HMDSO | 0.083 | FIG. 1 | N₂ | N₂ | 1 |
| Ex. 6 | 1 | HMDSO | 0.167 | FIG. 1 | N₂ | N₂ | 1 |
| Ex. 7 | 1 | HMDSO | 0.300 | FIG. 1 | N₂ | N₂ | 1 |
| Ex. 8 | 1 | HMDSO | 0.017 | FIG. 1 | N₂ | N₂ | 5 |
| Ex. 9 | 1 | HMDSO | 0.067 | FIG. 1 | N₂ | N₂ | 5 |
| Ex. 10 | 1 | HMDSO | 0.200 | FIG. 1 | N₂ | N₂ | 5 |
| Ex. 11 | 1 | HMDSO | 0.300 | FIG. 1 | N₂ | N₂ | 5 |
| Ex. 12 | 1 | HMDSO | 0.007 | FIG. 1 | N₂ | N₂ | 50 |
| Ex. 13 | 1 | HMDSO | 0.020 | FIG. 1 | N₂ | N₂ | 50 |
| Ex. 14 | 1 | HMDSO | 0.050 | FIG. 1 | N₂ | N₂ | 50 |
| Ex. 15 | 1 | HMDSO | 0.007 | FIG. 1 | N₂ | N₂ | 100 |
| Ex. 16 | 1 | HMDSO | 0.017 | FIG. 1 | N₂ | N₂ | 100 |
| Ex. 17 | 1 | HMDSO | 0.025 | FIG. 1 | N₂ | N₂ | 100 |
| Ex. 18 | 1 | HMDSO | 0.022 | FIG. 1 | N₂ | Dry air | 15 |
| Ex. 19 | 1 | HMDSO | 0.022 | FIG. 1 | Dry air | N₂ | 15 |
| Ex. 20 | 1 | HMDSO | 0.022 | FIG. 1 | Dry air | Dry air | 15 |
| Ex. 21 | 1 | TMDSO | 0.022 | FIG. 1 | N₂ | N₂ | 15 |
| Ex. 22 | 1 | OMTSO | 0.022 | FIG. 1 | N₂ | N₂ | 15 |
| Ex. 23 | 1 | TEOS | 0.022 | FIG. 1 | N₂ | N₂ | 15 |
| Ex. 24 | 1 | PTMEOS | 0.022 | FIG. 1 | N₂ | N₂ | 15 |
| Ex. 25 | 1 | TFPTMOS | 0.022 | FIG. 1 | N₂ | N₂ | 15 |
| Ex. 26 | 1 | GPTMOS | 0.022 | FIG. 1 | N₂ | N₂ | 15 |
| CE. 1 | 1 | HMDSO | 0.004 | FIG. 1 | N₂ | N₂ | 40 |
| CE. 2 | 1 | HMDSO | 0.330 | FIG. 1 | N₂ | N₂ | 5 |
| CE. 3 | 1 | HMDSO | 0.022 | FIG. 2 | N₂ | - | 15 |
| CE. 4 | 1 | Si based | - | Wet | - | - | - |
| CE. 5 | 1 | F based | - | Wet | - | - | - |
| CE. 6 | 1 | - | - | - | - | - | - |

**[Table 3]**

| | Coating Thickness(nm) | | | | Evaluation of Surface State | | | | | | Silicon Content (ppm) | Wett-ability | Heat Cycle |
|---|---|---|---|---|---|---|---|---|---|---|---|---|---|
| | | | | | Initial | | | After Testing | | | | | |
| | 0 | 90 | 180 | Max-min | 0 | 90 | 180 | 0 | 90 | 180 | | | |
| Ex. 1 | 14.3 | 14.8 | 13.8 | 1.0 | ○ | ○ | ○ | ○ | ○ | ○ | 13 | ○ | ○ |
| Ex. 2 | 7.2 | 6.9 | 7.4 | 0.5 | ○ | ○ | ○ | ○ | ○ | ○ | 6 | ○ | ○ |
| Ex. 3 | 4.3 | 4.2 | 4.5 | 0.3 | ○ | ○ | ○ | ○ | ○ | ○ | 3 | ○ | ○ |
| Ex. 4 | 112.0 | 112.9 | 112.1 | 0.9 | ○ | ○ | ○ | ○ | ○ | ○ | 105 | ○ | ○ |
| Ex. 5 | 56.0 | 55.6 | 56.9 | 1.3 | ○ | ○ | ○ | ○ | ○ | ○ | 52 | ○ | ○ |
| Ex. 6 | 108.0 | 107.3 | 108.7 | 1.4 | ○ | ○ | ○ | ○ | ○ | ○ | 101 | ○ | ○ |
| Ex. 7 | 198.0 | 197.2 | 196.6 | 1.4 | ○ | ○ | ○ | ○ | ○ | ○ | 186 | ○ | ○ |
| Ex. 8 | 12.0 | 11.5 | 12.5 | 1.0 | ○ | ○ | ○ | ○ | ○ | ○ | 11 | ○ | ○ |
| Ex. 9 | 44.5 | 44.1 | 43.7 | 0.8 | ○ | ○ | ○ | ○ | ○ | ○ | 41 | ○ | ○ |
| Ex. 10 | 134.5 | 135.2 | 136.1 | 1.6 | ○ | ○ | ○ | ○ | ○ | ○ | 126 | ○ | ○ |
| Ex. 11 | 197.6 | 198.4 | 197.0 | 1.4 | ○ | ○ | ○ | ○ | ○ | ○ | 185 | ○ | ○ |
| Ex. 12 | 4.5 | 4.2 | 4.7 | 0.5 | ○ | ○ | ○ | ○ | ○ | ○ | 4 | ○ | ○ |
| Ex. 13 | 13.6 | 12.9 | 14.3 | 1.4 | ○ | ○ | ○ | ○ | ○ | ○ | 12 | ○ | ○ |
| Ex. 14 | 34.6 | 33.1 | 35.3 | 2.2 | ○ | ○ | ○ | ○ | ○ | ○ | 32 | ○ | ○ |
| Ex. 15 | 4.6 | 4.0 | 4.8 | 0.8 | ○ | ○ | ○ | ○ | ○ | ○ | 4 | ○ | ○ |
| Ex. 16 | 10.9 | 11.2 | 11.8 | 0.9 | ○ | ○ | ○ | ○ | ○ | ○ | 10 | ○ | ○ |
| Ex. 17 | 16.3 | 15.7 | 15.1 | 1.2 | ○ | ○ | ○ | ○ | ○ | ○ | 15 | ○ | ○ |
| Ex. 18 | 13.4 | 13.9 | 12.5 | 1.4 | ○ | ○ | ○ | ○ | ○ | ○ | 12 | ○ | ○ |
| Ex. 19 | 12.0 | 11.5 | 12.3 | 0.8 | ○ | ○ | ○ | ○ | ○ | ○ | 11 | ○ | ○ |
| Ex. 20 | 10.5 | 10.8 | 9.1 | 1.7 | ○ | ○ | ○ | ○ | ○ | ○ | 9 | ○ | ○ |
| Ex. 21 | 12.5 | 12.1 | 11.7 | 0.8 | ○ | ○ | ○ | ○ | ○ | ○ | 11 | ○ | ○ |
| Ex. 22 | 17.2 | 16.4 | 17.8 | 1.4 | ○ | ○ | ○ | ○ | ○ | ○ | 16 | ○ | ○ |
| Ex. 23 | 12.8 | 12.4 | 12.0 | 0.8 | ○ | ○ | ○ | ○ | ○ | ○ | 11 | ○ | ○ |
| Ex. 24 | 13.7 | 13.5 | 12.8 | 0.9 | ○ | ○ | ○ | ○ | ○ | ○ | 13 | ○ | ○ |
| Ex. 25 | 13.2 | 12.6 | 12.1 | 0.9 | ○ | ○ | ○ | ○ | ○ | ○ | 13 | ○ | ○ |
| Ex. 26 | 12.4 | 11.8 | 13.2 | 1.4 | ○ | ○ | ○ | ○ | ○ | ○ | 11 | ○ | ○ |
| CE. 1 | 2.5 | 3.2 | 2.8 | 0.7 | ○ | ○ | ○ | X | X | X | 2 | ○ | ○ |
| CE. 2 | 225.5 | 227.2 | 226.7 | 1.7 | ○ | ○ | ○ | ○ | ○ | ○ | 211 | Δ | Δ |
| CE. 3 | 16.5 | 6.5 | 2.3 | 14.2 | ○ | ○ | ○ | ○ | ○ | X | 5 | Δ | ○ |
| CE. 4 | 11000 | 6000 | 9000 | 5000 | ○ | ○ | ○ | ○ | ○ | ○ | 1204 | X | X |
| CE. 5 | 72100 | 20010 | 45380 | 52090 | ○ | ○ | ○ | ○ | ○ | ○ | - | X | X |
| CE. 6 | - | - | - | - | ○ | ○ | ○ | X | X | X | - | ○ | ○ |

### (Examples 27 to 34)

Except for using Pb based solder wires illustrated in Table 4 as the solder wire base material, coated solder wires were made in the same way as in Example 1, and evaluated according to items (a) to (e) above. The results are given in Table 5.

### (Comparative Examples 7 to 14)

A coating film was not formed on the Pb based solder wires given in Table 4, and evaluation was performed according to items (b), (d) and (e) above. The results are given in Table 5.

**[Table 4]**

| | Solder Wire (Sample No.) | Coating Material | | Coating Method | Processing Conditions | | |
|---|---|---|---|---|---|---|---|
| | | Type | Used Amount (g/m) | | Reaction Gas | Helical Gas Flow | Transporting Speed (m/min) |
| Ex. 27 | 2 | HMDSO | 0.022 | FIG. 1 | N₂ | N₂ | 15 |
| Ex. 28 | 3 | HMDSO | 0.022 | FIG. 1 | N₂ | N₂ | 15 |
| Ex. 29 | 4 | HMDSO | 0.022 | FIG. 1 | N₂ | N₂ | 15 |
| Ex. 30 | 5 | HMDSO | 0.022 | FIG. 1 | N₂ | N₂ | 15 |
| Ex. 31 | 6 | HMDSO | 0.022 | FIG. 1 | N₂ | N₂ | 15 |
| Ex. 32 | 7 | HMDSO | 0.022 | FIG. 1 | N₂ | N₂ | 15 |
| Ex. 33 | 8 | HMDSO | 0.022 | FIG. 1 | N₂ | N₂ | 15 |
| Ex. 34 | 9 | HMDSO | 0.022 | FIG. 1 | N₂ | N₂ | 15 |
| CE. 7 | 2 | - | - | - | - | - | - |
| CE. 8 | 3 | - | - | - | - | - | - |
| CE. 9 | 4 | - | - | - | - | - | - |
| CE. 10 | 5 | - | - | - | - | - | - |
| CE. 11 | 6 | - | - | - | - | - | - |
| CE. 12 | 7 | - | - | - | - | - | - |
| CE. 13 | 8 | - | - | - | - | - | - |
| CE. 14 | 9 | - | - | - | - | - | - |

**[Table 5]**

| | Coating Thickness(nm) | | | | Evaluation of Surface State | | | | | | Silicon Content (ppm) | Wett-ability | Heat Cycle |
|---|---|---|---|---|---|---|---|---|---|---|---|---|---|
| | | | | | Initial | | | After Testing | | | | | |
| | 0 | 90 | 180 | Max-min | 0 | 90 | 180 | 0 | 90 | 180 | | | |
| Ex. 27 | 15.2 | 15.8 | 14.5 | 1.3 | ○ | ○ | ○ | ○ | ○ | ○ | 14 | ○ | ○ |
| Ex. 28 | 14.2 | 14.8 | 14.1 | 0.7 | ○ | ○ | ○ | ○ | ○ | ○ | 13 | ○ | ○ |
| Ex. 29 | 13.8 | 14.3 | 14.7 | 0.9 | ○ | ○ | ○ | ○ | ○ | ○ | 12 | ○ | ○ |
| Ex. 30 | 14.7 | 13.6 | 14.3 | 1.1 | ○ | ○ | ○ | ○ | ○ | ○ | 13 | ○ | ○ |
| Ex. 31 | 14.9 | 14.5 | 13.9 | 1.0 | ○ | ○ | ○ | ○ | ○ | ○ | 13 | ○ | ○ |
| Ex. 32 | 13.9 | 13.6 | 14.5 | 0.9 | ○ | ○ | ○ | ○ | ○ | ○ | 14 | ○ | ○ |
| Ex. 33 | 14.0 | 13.4 | 14.7 | 1.3 | ○ | ○ | ○ | ○ | ○ | ○ | 12 | ○ | ○ |
| Ex. 34 | 15.7 | 15.9 | 16.3 | 0.6 | ○ | ○ | ○ | ○ | ○ | ○ | 15 | ○ | ○ |
| CE. 7 | - | - | - | - | ○ | ○ | ○ | X | X | X | - | ○ | ○ |
| CE. 8 | - | - | - | - | ○ | ○ | ○ | X | X | X | - | ○ | ○ |
| CE. 9 | - | - | - | - | ○ | ○ | ○ | X | X | X | - | ○ | ○ |
| CE.10 | - | - | - | - | ○ | ○ | ○ | X | X | X | - | ○ | ○ |
| CE.11 | - | - | - | - | ○ | ○ | ○ | X | X | X | - | ○ | ○ |
| CE.12 | - | - | - | - | ○ | ○ | ○ | X | X | X | - | ○ | ○ |
| CE.13 | - | - | - | - | ○ | ○ | ○ | X | X | X | - | ○ | ○ |
| CE.14 | - | - | - | - | ○ | ○ | ○ | X | X | X | - | ○ | ○ |

### (Examples 35 to 43)

Except for using the Sn based solder wires given in Table 6 as the solder wire base material, coated solder wires were made in the same way as in Example 1, and evaluated according to items (a) to (e) above. The results are given in Table 7.

### (Comparative Examples 15 to 23)

A coating film was not formed on the Pb based solder wires given in Table 6, and evaluation was performed according to items (b), (d) and (e) above. The results are given in Table 7.

**[Table 6]**

| | Solder Wire (Sample No.) | Coating Material | | Coating Method | Processing Conditions | | |
|---|---|---|---|---|---|---|---|
| | | Type | Used Amount (g/m) | | Reaction Gas | Helical Gas Flow | Transporting Speed (m/min) |
| Ex. 35 | 10 | HMDSO | 0.022 | FIG. 1 | N₂ | N₂ | 15 |
| Ex. 36 | 11 | HMDSO | 0.022 | FIG. 1 | N₂ | N₂ | 15 |
| Ex. 37 | 12 | HMDSO | 0.022 | FIG. 1 | N₂ | N₂ | 15 |
| Ex. 38 | 13 | HMDSO | 0.022 | FIG. 1 | N₂ | N₂ | 15 |
| Ex. 39 | 14 | HMDSO | 0.022 | FIG. 1 | N₂ | N₂ | 15 |
| Ex. 40 | 15 | HMDSO | 0.022 | FIG. 1 | N₂ | N₂ | 15 |
| Ex. 41 | 16 | HMDSO | 0.022 | FIG. 1 | N₂ | N₂ | 15 |
| Ex. 42 | 17 | HMDSO | 0.022 | FIG. 1 | N₂ | N₂ | 15 |
| Ex. 43 | 18 | HMDSO | 0.022 | FIG. 1 | N₂ | N₂ | 15 |
| CE. 15 | 10 | - | - | - | - | - | - |
| CE. 16 | 11 | - | - | - | - | - | - |
| CE. 17 | 12 | - | - | - | - | - | - |
| CE. 18 | 13 | - | - | - | - | - | - |
| CE. 19 | 14 | - | - | - | - | - | - |
| CE. 20 | 15 | - | - | - | - | - | - |
| CE. 21 | 16 | - | - | - | - | - | - |
| CE. 22 | 17 | - | - | - | - | - | - |
| CE. 23 | 18 | - | - | - | - | - | - |

**[Table 7]**

| | Coating Thickness(nm) | | | | Evaluation of Surface State | | | | | | Silicon Content (ppm) | Wett-ability | Heat Cycle |
|---|---|---|---|---|---|---|---|---|---|---|---|---|---|
| | | | | | Initial | | | After Testing | | | | | |
| | 0 | 90 | 180 | Max-min | 0 | 90 | 180 | 0 | 90 | 180 | | | |
| Ex. 35 | 14.6 | 14.3 | 14.8 | 0.5 | ○ | ○ | ○ | ○ | ○ | ○ | 14 | ○ | ○ |
| Ex. 36 | 14.7 | 14.1 | 15.2 | 1.1 | ○ | ○ | ○ | ○ | ○ | ○ | 14 | ○ | ○ |
| Ex. 37 | 15.7 | 16.4 | 16.8 | 1.1 | ○ | ○ | ○ | ○ | ○ | ○ | 15 | ○ | ○ |
| Ex. 38 | 13.5 | 13.7 | 13.9 | 0.4 | ○ | ○ | ○ | ○ | ○ | ○ | 13 | ○ | ○ |
| Ex. 39 | 15.1 | 14.7 | 15.6 | 0.9 | ○ | ○ | ○ | ○ | ○ | ○ | 15 | ○ | ○ |
| Ex. 40 | 13.3 | 13.1 | 13.7 | 0.6 | ○ | ○ | ○ | ○ | ○ | ○ | 12 | ○ | ○ |
| Ex. 41 | 14.1 | 15.0 | 14.5 | 0.9 | ○ | ○ | ○ | ○ | ○ | ○ | 13 | ○ | ○ |
| Ex. 42 | 13.9 | 13.8 | 14.3 | 0.5 | ○ | ○ | ○ | ○ | ○ | ○ | 13 | ○ | ○ |
| Ex. 43 | 14.5 | 15.3 | 14.1 | 1.2 | ○ | ○ | ○ | ○ | ○ | ○ | 14 | ○ | ○ |
| CE.15 | - | - | - | - | ○ | ○ | ○ | X | X | X | - | ○ | ○ |
| CE.16 | - | - | - | - | ○ | ○ | ○ | X | X | X | - | ○ | ○ |
| CE.17 | - | - | - | - | ○ | ○ | ○ | X | X | X | - | ○ | ○ |
| CE.18 | - | - | - | - | ○ | ○ | ○ | X | X | X | - | ○ | ○ |
| CE.19 | - | - | - | - | ○ | ○ | ○ | X | X | X | - | ○ | ○ |
| CE.20 | - | - | - | - | ○ | ○ | ○ | X | X | X | - | ○ | ○ |
| CE.21 | - | - | - | - | ○ | ○ | ○ | X | X | X | - | ○ | ○ |
| CE.22 | - | - | - | - | ○ | ○ | ○ | X | X | X | - | ○ | ○ |
| CE.23 | - | - | - | - | ○ | ○ | ○ | X | X | X | - | ○ | ○ |

### [Evaluation Results]

As can be seen from the results given in Table 3, Table 5 and Table 7, the coated solder wires of Examples 1 to 43 are such that the thickness of the coating film is within the range 4 nm to 200 nm, there is very little variation in the thickness of the coating film, and the silicon compound content (ratio of the coating film calculated in terms of silicon) is within 200 ppm. Particularly, as can be understood by referencing FIGS. 3a to 3D and FIGS. 4A and 4B and from the results given in Table 3, the coated solder wire of Example 1 is such that the maximum difference in the thickness at each position is kept within the range of 1.0 nm, and when compared with Comparative Example 3 of which that maximum difference is 14.2 nm, there is a great improvement in the uniformity of the coating film.

Moreover, the coated solder wires of Examples 1 to 43 have hardly any change in the surface state before and after the neutral salt spray test, have excellent oxidation resistance, and the evaluation of the wettability and heat cycle is also good.

In addition, the processing time for Example 1 is kept to 1/3 or less than the processing time for Comparative Example 3. Therefore, by applying the manufacturing method of the present invention, it is possible to greatly improve the productivity of coated solder wire.

### [Explanation of Reference Numbers]

- 1: Coated solder wire
- 2: Solder wire
- 3, 3a, 3b, 3c: Coating film
- 4: Helical gas flow
- 5: Radicalized organic silicon compound
- 6: Reaction area
- 7a, 7b, 7c: Surface of transport jig
- 8: Nozzle
- A: Transporting direction of solder wire

## Claims

1. A coated solder wire (1) comprising:
a solder wire (2); and
a coating film (3, 3a, 3b, 3c) made from polysiloxane and provided on the surface of the solder wire (2);
the coating film (3, 3a, 3b, 3c) having a thickness of 4 nm to 200 nm, with the difference between the maximum value and minimum value of the thickness being within 2.5 nm, and the ratio of the coating film (3, 3a, 3b, 3c) with respect to the overall coated solder wire (1) being 200 ppm of mass or less in terms of silicon conversion.

2. The coated solder wire (1) according to Claim 1, wherein
the solder wire (2) comprises a solder alloy including Pb at 80% by mass or greater and at least one or more kind of a second element selected from among a group of Sn, Ag, Cu, In, Te and P, with the total content of the Pb and second element being 95% by mass or greater.

3. The coated solder wire (1) according to Claim 1, wherein
the solder wire (2) comprises a solder alloy including Sn at 80% by mass or greater and at least one or more kind of a second element selected from among a group of Ag, Sb, Cu, Ni, Ge and P, with the total content of the Sn and second element being 95% by mass or greater.

4. A manufacturing method for a coated solder wire (1), comprising:
a radicalization step for forming a radicalized organic silicon compound by mixing a reaction gas that has been plasmatized under atmospheric pressure and an organic silicon compound that is introduced by way of a carrier gas such that the amount of the organic silicon compound introduced per 1 m of the solder wire (2) is 0.006 g to 0.300 g, and radicalizing the organic silicon compound;
a reaction area formation step for forming a reaction area that is defined by a helical gas flow and in which the radicalized organic silicon compound is uniformly dispersed; and
a coating step for forming a 4 nm to 200 nm thick coating film (3, 3a, 3b, 3c) made from polysiloxane, with the difference between the maximum value and minimum value of the thickness being within 2.5 nm, and the ratio of the coating film (3, 3a, 3b, 3c) with respect to the overall coated solder wire (1) being 200 ppm of mass or less in terms of silicon conversion, on the surface of a solder wire (2) by transporting the solder wire (2) inside the reaction area and causing the radicalized organic silicon compound to react with metal on the surface of the solder wire (2).

5. The manufacturing method for a coated solder wire (1) according to Claim 4, wherein
in the reaction area formation step, the reaction area is formed by mixing the radicalized organic silicon compound in the helical gas flow that is introduced beforehand.

6. The manufacturing method for a coated solder wire (1) according to Claim 5, wherein
the helical gas flow is formed by at least one type of gas selected from among a group of argon, helium, nitrogen, oxygen and air.

7. The manufacturing method for a coated solder wire (1) according to any one of Claims 4 to 6, wherein
an organic silicon compound having at least one kind of organic substituent selected from among a group of an alkyl group, alkoxy group, fluoroalkyl group, amino group, epoxy group, isocyanate group, mercapto group, vinyl group, methacryloxy group, and acryloxy group is used as the organic silicon compound.

8. The manufacturing method for a coated solder wire (1) according to any one of Claims 4 to 7, wherein
at least one kind of gas selected from among a group of argon, helium, nitrogen, oxygen and air is used as the reaction gas.

9. The manufacturing method for a coated solder wire (1) according to any one of Claims 4 to 8, wherein
at least one kind of gas selected from among argon, helium and nitrogen is used as the carrier gas.

10. The manufacturing method for a coated solder wire (1) according to any one of Claims 4 to 9, wherein
in the radicalization step, the organic silicon compound is radicalized by using an atmospheric pressure plasma polymerization processor.

11. The manufacturing method for a coated solder wire (1) according to Claim 4, wherein
the transporting speed of the solder wire (2) in the coating process is 1 m/min to 100 m/min.

## Patentansprüche

1. Beschichteter Lötdraht (1), umfassend:
einen Lötdraht (2); und
einen Beschichtungsfilm (3, 3a, 3b, 3c) aus Polysiloxan, der auf der Oberfläche des Lötdrahtes (2) vorgesehen ist; wobei
der Beschichtungsfilm (3, 3a, 3b, 3c) eine Dicke von 4 nm bis 200 nm aufweist, wobei die Differenz zwischen dem Maximalwert und dem Minimalwert der Dicke innerhalb von 2,5 nm liegt, und das Verhältnis des Beschichtungsfilms (3, 3a, 3b, 3c), in Bezug auf den gesamten beschichteten Lötdraht (1) 200 ppm Masse oder weniger in Bezug auf die Siliziumumwandlung beträgt.

2. Beschichteter Lötdraht (1) nach Anspruch 1, wobei
der Lötdraht (2) eine Lötlegierung umfasst, die Pb mit 80 Masse-% oder mehr und mindestens eine oder mehrere Arten eines zweiten Elements ausgewählt aus einer Gruppe von Sn, Ag, Cu, In, Te und P enthält, wobei der Gesamtgehalt des Pb und des zweiten Elements 95 Masse-% oder mehr beträgt.

3. Beschichteter Lötdraht (1) nach Anspruch 1, wobei
der Lötdraht (2) eine Lötlegierung umfasst, die Sn mit 80 Masse-% oder mehr und mindestens eine oder mehrere Arten eines zweiten Elements ausgewählt aus einer Gruppe von Ag, Sb, Cu, Ni, Ge und P enthält, wobei der Gesamtgehalt des Sn und des zweiten Elements 95 Masse-% oder mehr beträgt.

4. Herstellungsverfahren für einen beschichteten Lötdraht (1), umfassend:
einen Radikalisierungsschritt zur Bildung einer radikalisierten organischen Siliciumverbindung durch Mischen eines unter Normaldruck plasmatisierten Reaktionsgases und einer organischen Siliciumverbindung, die über ein Trägergas derart eingeleitet wird, dass die Menge der eingebrachten organischen Siliciumverbindung pro 1 m des Lötdrahts (2) 0,006 g bis 0,300 g beträgt und die organische Siliciumverbindung radikalisiert;
einen Reaktionsbereichsbildungsschritt zum Bilden eines Reaktionsbereichs, der durch einen helixförmigen Gasstrom definiert ist und in dem die radikalisierte organische Siliciumverbindung gleichmäßig dispergiert ist; und
einen Beschichtungsschritt zum Ausbilden eines 4 nm bis 200 nm dicken Beschichtungsfilms (3, 3a, 3b, 3c) aus Polysiloxan, wobei die Differenz zwischen dem Maximalwert und dem Minimalwert der Dicke innerhalb von 2,5 nm liegt und das Verhältnis des Beschichtungsfilms (3, 3a, 3b, 3c) in Bezug auf den gesamten beschichteten Lötdraht (1), der 200 ppm Masse oder weniger in Bezug auf die Siliziumumwandlung aufweist, auf der Oberfläche eines Lötdrahtes (2) durch Transportieren des Lötdrahtes (2) innerhalb des Reaktionsbereichs und Bewirken, dass die radikalisierte organische Siliziumverbindung mit Metall auf der Oberfläche des Lötdrahtes (2) reagiert.

5. Herstellungsverfahren für einen beschichteten Lötdraht (1) nach Anspruch 4, wobei
in dem Reaktionsbereichsbildungsschritt der Reaktionsbereich durch Mischen der radikalisierten organischen Siliciumverbindung in den zuvor eingeführten helixförmigen Gasstrom gebildet wird.

6. Herstellungsverfahren für einen beschichteten Lötdraht (1) nach Anspruch 5, wobei
der helixförmige Gasstrom durch mindestens einen Gastyp gebildet wird, der aus einer Gruppe von Argon, Helium, Stickstoff, Sauerstoff und Luft ausgewählt ist.

7. Herstellungsverfahren für einen beschichteten Lötdraht (1) nach einem der Ansprüche 4 bis 6, wobei
eine organische Siliciumverbindung mit mindestens einer Art von organischem Substituenten, ausgewählt aus einer Gruppe aus einer Alkylgruppe, Alkoxygruppe, Fluoralkylgruppe, Aminogruppe, Epoxygruppe, Isocyanatgruppe, Mercaptogruppe, Vinylgruppe, Methacryloxygruppe und Acryloxygruppe, als organische Siliciumverbindung verwendet wird.

8. Herstellungsverfahren für einen beschichteten Lötdraht (1) nach einem der Ansprüche 4 bis 7, wobei
als Reaktionsgas mindestens eine Gasart verwendet wird, die aus einer Gruppe von Argon, Helium, Stickstoff, Sauerstoff und Luft ausgewählt ist.

9. Herstellungsverfahren für einen beschichteten Lötdraht (1) nach einem der Ansprüche 4 bis 8, wobei
als Trägergas mindestens eine Gasart verwendet wird, die aus Argon, Helium und Stickstoff ausgewählt ist.

10. Herstellungsverfahren für einen beschichteten Lötdraht (1) nach einem der Ansprüche 4 bis 9, wobei
in dem Radikalisierungsschritt die organische Siliciumverbindung unter Verwendung eines Atmosphärendruck-Plasmapolymerisationsprozessors radikalisiert wird.

11. Herstellungsverfahren für einen beschichteten Lötdraht (1) nach Anspruch 4, wobei
die Transportgeschwindigkeit des Lötdrahtes (2) im Beschichtungsprozess 1 m / min bis 100 m / min beträgt.

## Revendications

1. Fil de brasage revêtu (1) comprenant :
un fil de brasage (2) ; et
un film de revêtement (3, 3a, 3b, 3c) fait de polysiloxane et disposé sur la surface du fil de brasage (2) ;
le film de revêtement (3, 3a, 3b, 3c) ayant une épaisseur de 4 nm à 200 nm, la différence entre la valeur maximale et la valeur minimale de l'épaisseur étant de l'ordre de 2,5 nm, et le rapport du film de revêtement (3, 3a, 3b, 3c) au fil de brasage revêtu global (1) étant de 200 ppm en masse ou moins en termes de conversion du silicium.

2. Fil de brasage revêtu (1) selon la revendication 1, dans lequel
le fil de brasage (2) comprend un alliage de brasage contenant du Pb à raison de 80 % en masse ou plus et au moins un ou plusieurs types d'un deuxième élément choisi parmi Sn, Ag, Cu, In, Te et P, la teneur totale en Pb et en le deuxième élément étant de 95 % en masse ou plus.

3. Fil de brasage revêtu (1) selon la revendication 1, dans lequel
le fil de brasage (2) comprend un alliage de brasage contenant du Sn à raison de 80 % en masse ou plus et au moins un ou plusieurs types d'un deuxième élément choisi parmi Ag, Sb, Cu, Ni, Ge et P, la teneur totale en Sn et en le deuxième élément étant de 95 % en masse ou plus.

4. Procédé de fabrication d'un fil de brasage revêtu (1), comprenant :
une étape de radicalisation pour former un composé siliconé organique radicalisé par mélange d'un gaz réactionnel qui a été plasmatisé sous la pression atmosphérique et d'un composé organique du silicium qui est introduit au moyen d'un gaz porteur de façon que la quantité du composé organique du silicium introduit par mètre de fil de brasage (2) soit de 0,006 g à 0,300 g, et pour radicaliser le composé organique du silicium ;
une étape de formation de zone réactionnelle pour former une zone réactionnelle qui est définie par un flux gazeux hélicoïdal et dans laquelle le composé organique du silicium radicalisé est dispersé uniformément ; et
une étape de revêtement pour former un film de revêtement (3, 3a, 3b, 3c) ayant une épaisseur de 4 nm à 200 nm fait de polysiloxane, la différence entre la valeur maximale et la valeur minimale de l'épaisseur étant de l'ordre de 2,5 nm, et le rapport du film de revêtement (3, 3a, 3b, 3c) au fil de brasage revêtu global (1) étant de 200 ppm en masse ou moins en termes de conversion du silicium, sur la surface d'un fil de brasage (2) par transport du fil de brasage (2) à l'intérieur de la zone réactionnelle et réaction du composé organique du silicium radicalisé avec le métal sur la surface du fil de brasage (2).

5. Procédé de fabrication d'un fil de brasage revêtu (1) selon la revendication 4, dans lequel
dans l'étape de formation de zone réactionnelle, la zone réactionnelle est formée par mélange du composé organique du silicium radicalisé dans le flux gazeux hélicoïdal qui a été introduit auparavant.

6. Procédé de fabrication d'un fil de brasage revêtu (1) selon la revendication 5, dans lequel
le flux gazeux hélicoïdal est formé d'au moins un type de gaz choisi parmi l'argon, l'hélium, l'azote, l'oxygène et l'air.

7. Procédé de fabrication d'un fil de brasage revêtu (1) selon l'une quelconque des revendications 4 à 6, dans lequel
un composé organique du silicium ayant au moins un type de substituant organique choisi parmi un groupe alkyle, un groupe alcoxy, un groupe fluoroalkyle, un groupe amino, un groupe époxy, un groupe isocyanate, un groupe mercapto, un groupe vinyle, un groupe méthacryloxy, et un groupe acryloxy, est utilisé en tant que composé organique du silicium.

8. Procédé de fabrication d'un fil de brasage revêtu (1) selon l'une quelconque des revendications 4 à 7, dans lequel
au moins un type de gaz choisi parmi l'argon, l'hélium, l'azote, l'oxygène et l'air est utilisé en tant que gaz réactionnel.

9. Procédé de fabrication d'un fil de brasage revêtu (1) selon l'une quelconque des revendications 4 à 8, dans lequel
au moins un type de gaz choisi parmi l'argon, l'hélium et l'azote est utilisé en tant que gaz porteur.

10. Procédé de fabrication d'un fil de brasage revêtu (1) selon l'une quelconque des revendications 4 à 9, dans lequel
dans l'étape de radicalisation, le composé organique du silicium est radicalisé par utilisation d'un dispositif de traitement de polymérisation par plasma sous la pression atmosphérique.

11. Procédé de fabrication d'un fil de brasage revêtu (1) selon la revendication 4, dans lequel
la vitesse de transport du fil de brasage (2) dans le traitement de revêtement est de 1 m/min à 100 m/min.
